# DEMANDE DE BREVET EUROPEEN

(11) **EP 2 269 722 A1**
(43) Date de publication de la demande: **05.01.2011**
(21) Numéro de dépôt: 10165548.8
(22) Date de dépôt: 10.06.2010
(51) Int. Cl.: B01J 19/00, B01L 3/00, B29C 65/54

(54) **Dispositif microfluidique comportant deux couches hydrophobes assemblées l'une à l'autre et procédé d'assemblage**

(30) Priorité: 11.06.2009 FR 0953880
(71) Demandeur: Commissariat à l'Énergie Atomique et aux Énergies Alternatives, 75015 Paris (FR)
(72) Inventeur: Delattre, Cyril, 38140, IZEAUX (FR); Bottausci, Frédéric, 83370, SAINT-AYGULF (FR)
(74) Mandataire: Augarde, Eric

(57) **Abrégé**

L'invention concerne un dispositif microfluidique comprenant un premier et un second substrats (1, 2) comportant, respectivement, une première et une seconde couches hydrophobes (13, 23) à base de polysiloxane, lesdites couches hydrophobes comprenant chacune une zone d'assemblage (15, 25).

Lesdits substrats (1, 2) sont assemblés l'un à l'autre au niveau desdites zones d'assemblage (15, 25) au moyen d'un adhésif (31) à base de silicone.

## Description

### DOMAINE TECHNIQUE

La présente invention se rapporte au domaine général de la microfluidique ainsi qu'à celui de l'assemblage de couches hydrophobes, nécessaire à la formation de dispositifs microfluidiques tels que, par exemple, des laboratoires sur puce.

L'invention concerne un dispositif microfluidique comportant deux couches hydrophobes assemblées l'une à l'autre. Elle concerne également un procédé d'assemblage desdites couches hydrophobes.

L'invention s'applique à tout dispositif à microfluidique continue ou à microfluidique discrète, ou à gouttes, permettant notamment de former, déplacer, mélanger, stocker de petits volumes de fluides en vue d'analyses biochimiques, chimiques ou biologiques, que ce soit dans le domaine médical, ou dans la surveillance environnementale, ou dans le domaine du contrôle de qualité.

### ETAT DE LA TECHNIQUE ANTERIEURE

Un dispositif microfluidique peut permettre de manipuler des échantillons de liquide de petit volume, par exemple des gouttes de quelques nanolitres à quelques microlitres.

Un tel dispositif peut se présenter en configuration ouverte où les échantillons sont manipulés à la surface d'un substrat, ou en configuration fermée dans laquelle les échantillons sont confinés entre un substrat inférieur et un substrat supérieur, ou capot.

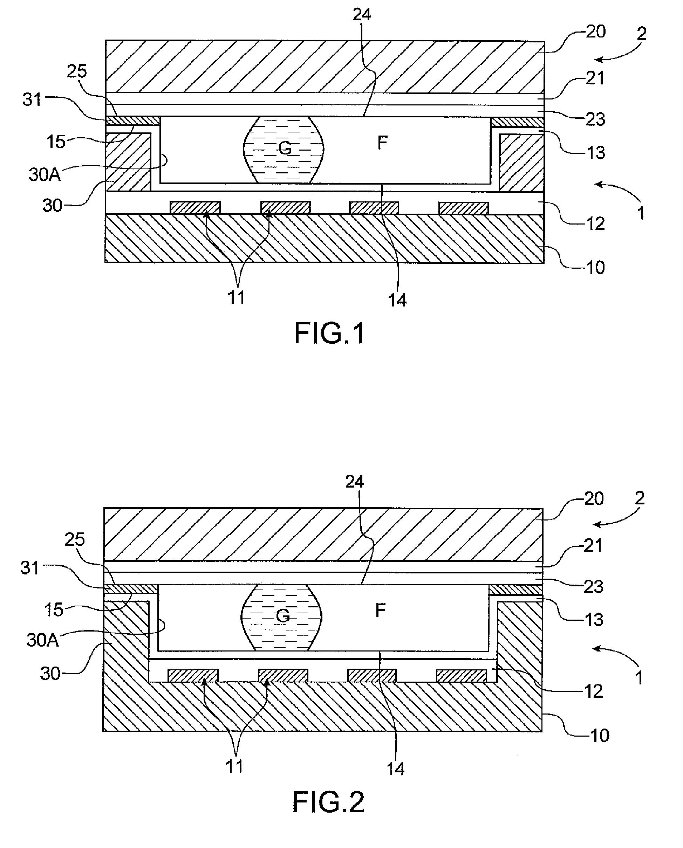

La figure 1 montre un exemple de dispositif microfluidique en configuration fermée. Il est à noter que les échelles ne sont pas respectées, pour privilégier la clarté du dessin.

Le substrat inférieur 1 comprend une couche support diélectrique 10 munie d'une matrice d'électrodes 11 indépendantes.

Chacune de ces électrodes 11 est connectée électriquement à un conducteur et peuvent être alimentées électriquement indépendamment les unes des autres, par un moyen d'adressage (non représenté).

Les électrodes 11 sont recouvertes d'une couche diélectrique 12 et d'une couche hydrophobe 13, formant une surface de déplacement 14.

Le substrat 1 est assemblé de manière étanche à un capot 2.

Le capot 2 comprend classiquement une couche diélectrique de fermeture 20 sur laquelle est disposée une contre-électrode 21 recouverte d'une couche hydrophobe 23.

Ainsi, le dispositif permet de déplacer, par l'alimentation successive des électrodes 11, un petit volume de liquide G sous forme de goutte suivant un chemin défini par la disposition des électrodes 11. La goutte G est environnée d'un fluide F immiscible et non-conducteur.

Les forces utilisées pour le déplacement sont des forces électrostatiques.

Le mode de déplacement ou de manipulation repose sur le principe de l'électromouillage sur un diélectrique, comme décrit dans l'article de Pollack et al. intitulé « Electrowetting-based actuation of droplets for integrated microfluidics », Lab. Chip 2 (1) 2002, pages 96-101. Ce document montre également des exemples de dispositifs microfluidiques en configuration fermée.

Pour définir précisément la distance qui sépare le capot 2 du substrat 1 et délimiter une cavité microfluidique étanche, des espaceurs 30, ou murs, peuvent être formés ou déposés sur la couche diélectrique 12 et positionnés à proximité de la bordure du substrat 1.

Il est à noter que, selon une variante de réalisation, les murs 30 peuvent être formés d'un seul tenant avec la couche support 10 du substrat 1, celui-ci étant alors micro-structuré.

La couche hydrophobe 13 est disposée de manière à recouvrir la couche diélectrique 12 du substrat 1 ainsi que, au moins partiellement, la surface des murs 30. Au niveau du capot 2, la couche hydrophobe 23 recouvre la contre-électrode 21.

L'assemblage du substrat 1 et du capot 2 est réalisé au niveau de leur couche hydrophobe respective 13, 23. Plus précisément, chaque couche hydrophobe 13, 23 présente une surface comportant une zone de déplacement 14, 24 qui participe à délimiter la cavité microfluidique et une zone d'assemblage 15, 25 destinée à être assemblée à la zone d'assemblage correspondante de la seconde couche hydrophobe.

Un certain nombre de difficultés se présente lors de l'assemblage du substrat et du capot au niveau des couches hydrophobes.

En effet, les couches hydrophobes sont habituellement réalisées en polymère fluoré, par exemple le Téflon^{®}, ou polytétrafluoroéthylène (PTFE), commercialisé par DuPont, ou le Cytop^{®} produit par Asahi Glass, voire réalisées en polydiméthylsiloxane (PDMS).

Or, il est connu que les adhésifs n'adhèrent pas suffisamment sur ce type de matériau, ce qui rend difficile voire impossible un collage direct entre la couche hydrophobe 13 du substrat 1 et celle 23 du capot 2, au niveau de leurs zones d'assemblage respectives 15, 25.

Aussi, lors de l'assemblage desdites surfaces 15, 25, il est classique de réaliser une étape de traitement de surface, préalablement à l'étape de collage, pour modifier les propriétés hydrophobes et/ou la rugosité de la surface des couches hydrophobes 13, 23.

Un traitement de surface par attaque chimique peut être effectué, par exemple avec le produit « Fluoroetch^{®} » commercialisé par Acton Technologies. Il est également possible de réaliser un traitement par attaque physique au plasma d'argon, tel que décrit dans l'article de S.-R. Kim intitulé « Studies on the surface changes and adhesion of PTFE by plasma and ion beam treatments » et publié en 1999 dans Korea Polymer Journal, 1999, 7(4), 250 [1].

Cette étape de traitement de surface rend possible le collage des couches hydrophobes 13, 23 au niveau de leurs zones d'assemblage respectives 15, 25, et l'utilisation de tout type de colle adaptée à la surface.

Cependant, l'utilisation de ces matériaux pour les couches hydrophobes entraîne un certain nombre d'inconvénients.

D'une part, comme il vient d'être expliqué, une étape de traitement de surface est nécessaire pour permettre le collage, ce qui rallonge et complexifie le procédé de fabrication du dispositif microfluidique. Le cycle de production est alors pénalisé en termes de coût et de temps.

Ensuite, le traitement de surface ne peut être simplement localisé aux seules zones d'assemblage 15, 25. En effet, les zones de déplacement 14, 24 des couches hydrophobes 13, 23 sont également impactées par le traitement de surface par attaque chimique ou physique, ce qui diminue les propriétés de mouillabilité de la couche hydrophobe dans ces zones. Plus précisément, son hydrophobie est diminuée, et sa rugosité augmentée (et donc l'hystérésis de mouillage), ce qui nuit grandement à l'efficacité et à la reproductibilité du déplacement des gouttes par électromouillage.

Il est à noter que la rugosité peut être définie comme la moyenne arithmétique des valeurs absolues des déviations verticales de la surface par rapport à une valeur moyenne.

Enfin, les techniques habituellement utilisées de dépôt du polydiméthylsiloxane (PDMS), du Téflon^{®} et des autres matériaux fluorés, par exemple l'enduction centrifuge (spin-coating) et le trempage-retrait (dip-coating), ne permettent pas d'obtenir une couche d'épaisseur homogène sur des surfaces présentant des structures en relief, telles que les murs 30, ce qui est préjudiciable pour le déplacement des gouttes.

Une alternative aux matériaux cités précédemment est d'utiliser, pour former la couche hydrophobe, un polysiloxane du type SiOC, notamment tel que décrit dans la demande de brevet WO 2007/003754 A1 déposée au nom de la demanderesse.

Comme le décrit ce document, le SiOC peut être déposé par voie chimique en phase gazeuse assisté par plasma (PECVD). Les propriétés de mouillabilité du matériau sont obtenues à partir du choix du précurseur et des caractéristiques de dépôt par PECVD.

L'utilisation du SiOC dans les dispositifs microfluidiques est décrite dans l'article de Thery et al. intitulé « SiOC as a hydrophobic layer for electrowetting on dielectric applications » et présenté lors de la Eleventh International Conference on Miniaturized Systems for Chemistry and Life Sciences (µTAS2007), 7-11 October 2007, Paris, France.

A la différence des techniques de dépôt des polymères fluorés ou du PDMS, la technique de dépôt du SiOC par PECVD est particulièrement adaptée aux surfaces présentant des rapports d'aspect élevés.

Cependant, les propriétés d'hydrophobie de ce matériau sont particulièrement sensibles aux traitements de surface habituellement nécessaires pour coller les deux couches hydrophobes.

Un traitement par action chimique ou physique tel que décrit précédemment entraîne en effet une dégradation importante de l'hydrophobie de la couche, et rend quasiment impossible le déplacement des gouttes.

Une alternative à cette étape de traitement de surface est alors de serrer le capot et le substrat l'un contre l'autre, au niveau des zones d'assemblage des couches hydrophobes.

Il est alors à noter que le capot et le substrat sont assemblés l'un à l'autre sans que les couches hydrophobes ne soient elles-mêmes assemblées l'une à l'autre. Celles-ci sont en simple contact mutuel au niveau de leur zone d'assemblage.

Par ailleurs, cette technique de serrage ne permet pas d'obtenir une cavité microfluidique parfaitement étanche.

### EXPOSÉ DE L'INVENTION

L'invention a principalement pour but de présenter un dispositif microfluidique comprenant un premier et un second substrats comportant, respectivement, une première et une seconde couches hydrophobes à base de polysiloxane, remédiant au moins en partie aux inconvénients mentionnés ci-dessus relatifs à la réalisation de l'art antérieur décrite en référence à la figure 1.

Pour ce faire, l'invention a pour objet un dispositif microfluidique comprenant un premier et un second substrats comportant, respectivement, une première et une seconde couches hydrophobes à base de polysiloxane, lesdites couches hydrophobes comprenant chacune une zone d'assemblage.

Selon l'invention, lesdits substrats sont assemblés l'un à l'autre au niveau des zones d'assemblage desdites couches hydrophobes au moyen d'un adhésif à base de silicone.

Ainsi, un adhésif à base de silicone permet d'assembler lesdits substrats du dispositif microfluidique, sans que les propriétés hydrophobes desdites couches hydrophobes ne soient altérées.

L'invention se distingue ainsi de l'art antérieur tel que décrit précédemment notamment par le fait que, dans l'art antérieur, les propriétés hydrophobes desdites couches hydrophobes sont nécessairement altérées pour réaliser l'assemblage des substrats.

Lesdits premier et second substrats forment chacun, de préférence, une pièce solide sensiblement incompressible.

Avantageusement, le premier substrat comprend au moins un mur disposé de manière à délimiter, conjointement avec ledit second substrat, une cavité microfluidique de déplacement de fluide, ladite première couche hydrophobe recouvrant au moins partiellement ledit mur.

Avantageusement, ladite première couche hydrophobe comprend une première surface formant une surface de déplacement de fluide, une deuxième surface formant ladite zone d'assemblage et située au niveau dudit mur, et une troisième surface de raccord entre lesdites première et deuxième surfaces et située au niveau dudit mur.

La première surface de la première couche hydrophobe, dite surface de déplacement de fluide, est située à l'intérieur de ladite cavité microfluidique.

Ladite troisième surface, dite de raccord, de la première couche hydrophobe s'étend entre lesdites première et seconde surfaces de la première couche hydrophobe.

Elle est donc disposée sur une paroi latérale interne du mur, plus précisément à l'intérieur de la cavité microfluidique.

Ladite troisième surface de raccord de la première couche hydrophobe peut s'étendre de manière sensiblement orthogonale vis-à-vis desdites première et deuxième surfaces de la première couche hydrophobe.

Ledit mur peut être un élément rapporté disposé au niveau dudit premier substrat ou être formé d'un seul tenant avec ledit premier substrat.

Ladite seconde couche hydrophobe comprend une première surface formant une surface de déplacement de fluide et une seconde surface formant ladite zone de d'assemblage, lesdites première et deuxième surfaces de la seconde couche hydrophobe étant situées en regard, respectivement, desdites première et deuxième surfaces de la première couche hydrophobe.

Ladite première couche hydrophobe peut être déposée à la surface du premier substrat et du mur de celui-ci par dépôt chimique en phase vapeur, assisté par plasma. Elle présente avantageusement une épaisseur sensiblement homogène, notamment au niveau desdites première, deuxième et troisième surfaces. Le déplacement de gouttes est alors possible de manière sensiblement homogène sur toute la surface de déplacement.

Ainsi, le dispositif microfluidique selon l'invention diffère des exemples de l'art antérieur dans lesquels la couche hydrophobe, lorsqu'elle est déposée par enduction centrifuge (« spin-coating ») ou par trempage-retrait (« dip-coating ») sur des substrats comprenant des murs, ne peut présenter une épaisseur sensiblement homogène, ce qui est préjudiciable pour le déplacement des gouttes.

Lors du dépôt chimique en phase vapeur assisté par plasma de la première couche hydrophobe sur le premier substrat et notamment sur le mur, ladite première couche hydrophobe est déposée au moins en partie sur la face supérieure du mur, ladite face supérieure étant orientée vers ledit second substrat. Cette partie de la couche forme la zone d'assemblage de la première couche hydrophobe, au niveau de laquelle le premier substrat est assemblé au second substrat.

Ainsi, par l'emploi de l'adhésif à base de silicone, l'invention permet d'assembler les premier et second substrats au niveau de la zone d'assemblage de leur couche hydrophobe respective, et donc d'obtenir une cavité microfluidique de déplacement de fluide, ou circuit microfluidique confiné.

Avantageusement, lesdites couches hydrophobes sont à base d'un polysiloxane pour lequel le rapport entre les liaisons -Si-O- linéaires et les liaisons -Si-O-cycliques est inférieur ou égal à 0,4, ou, de préférence, inférieur ou égal à 0,3. Ce matériau présente une faible hystérésis de mouillage et une surface hydrophobe. L'hystérésis de mouillage de ladite première couche hydrophobe peut ainsi être inférieure à 10° ou inférieure à 5°.

Le terme adhésif est ici entendu comme synonyme de colle.

Par silicone, on entend un polyorganosiloxane.

Ledit adhésif est de préférence un élastomère silicone.

Ledit adhésif peut être à base de silicone monocomposant ou multi-composant. Avantageusement, ledit adhésif est à base de fluorosilicone.

Selon un mode de réalisation préféré de l'invention, ledit adhésif est disposé entre les zones d'assemblages desdites couches hydrophobes.

Selon un autre mode de réalisation préféré de l'invention, les zones d'assemblage desdites couches hydrophobes sont au moins partiellement en contact mutuel, ledit adhésif étant situé à la périphérie extérieure de la jointure desdites zones d'assemblage.

De préférence, ledit premier substrat et ledit second substrat forment conjointement une cavité microfluidique de déplacement de fluide. Ladite première couche hydrophobe s'étend à la surface dudit premier substrat et ladite seconde couche hydrophobe s'étend à la surface du second substrat de manière à délimiter au moins partiellement ladite cavité microfluidique. De préférence, la cavité microfluidique est entièrement délimitée par lesdites première et seconde couches hydrophobes.

De préférence, ledit premier substrat comprend un réseau d'électrodes recouvertes d'une couche diélectrique, ladite première couche hydrophobe recouvrant ladite couche diélectrique, et ledit second substrat comprend une contre-électrode.

Alternativement, ledit premier substrat comprend une contre-électrode recouverte de la première couche hydrophobe, et ledit second substrat comprend un réseau d'électrodes recouvertes d'une couche diélectrique, ladite seconde couche hydrophobe recouvrant ladite couche diélectrique.

L'invention porte également sur un procédé d'assemblage d'un premier et d'un second substrats l'un à l'autre, lesdits substrats comportant, respectivement, une première et une seconde couches hydrophobes à base de polysiloxane, lesdites couches hydrophobes comprenant chacune une zone d'assemblage, ledit procédé étant **caractérisé en ce qu**'il comprend une étape de collage desdits substrats l'un à l'autre au niveau des zones d'assemblage desdites couches hydrophobes au moyen d'un adhésif à base de silicone.

Lesdites couches hydrophobes peuvent être formées, préalablement à ladite étape de collage, par trempage (dip-coating) ou tournage (spin-coating), ou formée par dépôt chimique en phase vapeur (CVD).

De préférence, lesdites première et seconde couches hydrophobes sont formées, respectivement, à la surface desdits premier et second substrats par dépôt chimique en phase vapeur, assisté par plasma dans lequel est injecté un précurseur choisi parmi les organosiloxanes cycliques et les organosilazanes cycliques, le rapport entre la densité de puissance dissipée dans le plasma et le débit de précurseur injecté dans le plasma étant inférieur ou égal à 100 W.cm⁻²/mol.min⁻¹.

Dans le cas d'un dépôt chimique en phase vapeur, le précurseur est avantageusement choisi parmi l'octaméthylcyclotétrasiloxane et ses dérivés, ou l'octaméthylcyclotétrasilazane et ses dérivés. Ledit précurseur utilisé peut également être choisi parmi l'hexaméthyldisiloxane et ses dérivés, le triméthylsilane et ses dérivés, le tétraméthylsilane et ses dérivés, le bis-triméthylsilylméthane et ses dérivés.

Par ailleurs, le précurseur est avantageusement dilué dans un gaz neutre ou oxydant avant d'être injecté dans le plasma, par exemple de l'azote, de l'oxygène, de l'hélium, ou encore, et de préférence, de l'hydrogène.

Avantageusement, ladite étape de collage desdits substrats est directement précédée de ladite étape de dépôt desdites première et seconde couches hydrophobes à la surface, respectivement, desdits premier et second substrats. En effet, il n'est pas nécessaire de réaliser, comme dans les exemples de l'art antérieur décrits précédemment, une étape de traitement de surface par attaque chimique ou physique qui altère les propriétés hydrophobes des couches hydrophobes.

De préférence, ledit premier substrat comprend au moins un mur disposé de manière à délimiter, conjointement avec ledit second substrat, une cavité microfluidique de déplacement de fluide, ladite étape de dépôt de la première couche hydrophobe étant réalisée de sorte que ladite première couche hydrophobe recouvre au moins partiellement ledit mur.

De préférence, ladite étape de collage comprend une étape de vulcanisation dudit adhésif avec dégagement d'acide acétique.

D'autres avantages et caractéristiques de l'invention apparaîtront dans la description détaillée non limitative ci-dessous.

### BRÈVE DESCRIPTION DES DESSINS

On décrira à présent, à titre d'exemples non limitatifs, des modes de réalisation de l'invention, en se référant aux dessins annexés, dans lesquels :
La figure 1, déjà décrite en relation avec un exemple de dispositif microfluidique selon l'art antérieur, est une vue schématique en coupe longitudinale d'un dispositif microfluidique présentant une cavité microfluidique délimitée notamment par des murs latéraux rapportés. La figure 1 illustre également un premier mode de réalisation préféré de l'invention ;
La figure 2 est une vue schématique en coupe longitudinale d'un dispositif microfluidique, selon un second mode de réalisation préféré de l'invention, présentant une cavité microfluidique délimitée notamment par des murs latéraux formés d'un seul tenant avec le substrat inférieur ;
La figure 3 est une vue schématique en coupe longitudinale d'un dispositif microfluidique, selon un troisième mode de réalisation préféré de l'invention, dans lequel l'adhésif est disposé à la périphérie extérieure de la jointure des couches hydrophobes ;
Les figures 4 et 5 sont des courbes illustrant l'évolution de la pression à l'intérieur d'une cavité microfluidique du dispositif microfluidique selon l'invention en fonction du nombre d'incréments d'augmentation de pression imposée.

### EXPOSÉ DÉTAILLÉ D'UN MODE DE RÉALISATION PREFERE

Les figures 1 à 3 illustrent un dispositif microfluidique selon trois modes de réalisation préférés de l'invention.
La figure 1 a été précédemment décrite en référence à un exemple de l'art antérieur. Elle illustre également la structure du dispositif microfluidique selon un premier mode de réalisation préféré de l'invention.

Comme décrit précédemment en référence à l'un des exemples de l'art antérieur, le substrat inférieur 1 comprend une couche support diélectrique 10 munie d'une matrice d'électrodes 11 indépendantes.

Chacune de ces électrodes 11 est connectée électriquement à un conducteur et peut être alimentée électriquement indépendamment les unes des autres, par un moyen d'adressage (non représenté).

Les électrodes 11 sont recouvertes d'une couche diélectrique 12 et d'une couche hydrophobe 13, formant une surface de déplacement 14.

Le substrat 1 est assemblé de manière étanche à un capot 2.

Le capot 2 comprend classiquement une couche diélectrique de fermeture 20 sur laquelle est disposée une contre-électrode 21 recouverte d'une couche hydrophobe 23.

Ainsi, le dispositif permet de déplacer, par l'alimentation successive des électrodes 11, un petit volume de liquide G sous forme de goutte suivant un chemin défini par la disposition des électrodes 11. La goutte G est environnée d'un fluide F immiscible et non-conducteur.

Les forces utilisées pour le déplacement sont des forces électrostatiques.

Le mode de déplacement ou de manipulation repose sur le principe de l'électromouillage sur un diélectrique, comme décrit dans l'article de Pollack et al. intitulé « Electrowetting-based actuation of droplets for integrated microfluidics », Lab. Chip 2 (1) 2002, pages 96-101. Ce document montre également des exemples de dispositifs microfluidiques en configuration fermée.

Pour définir précisément la distance qui sépare le capot 2 du substrat 1 et délimiter une cavité microfluidique étanche, des espaceurs 30, ou murs, peuvent être formés ou déposés sur la couche diélectrique 12 et positionnés à proximité de la bordure du substrat 1.

Le dispositif microfluidique présente une cavité microfluidique délimitée notamment par des murs latéraux rapportés.

Par mur rapporté, on entend un mur n'appartenant pas à la structure d'un autre élément du dispositif, ici la couche support du substrat 1, tel qu'il est décrit plus loin.

La couche hydrophobe 13 est disposée de manière à recouvrir la couche diélectrique 12 du substrat 1 ainsi que, au moins partiellement, la surface des murs 30. Au niveau du capot 2, la couche hydrophobe 23 recouvre la contre-électrode 21.

L'assemblage du substrat 1 et du capot 2 est réalisé au niveau de leur couche hydrophobe respective 13, 23. Plus précisément, chaque couche hydrophobe 13, 23 présente une surface comportant une zone de déplacement 14, 24 qui participe à délimiter la cavité microfluidique et une zone d'assemblage 15, 25 destinée à être assemblée à la zone d'assemblage correspondante de la seconde couche hydrophobe.

La première couche hydrophobe 13 comprend en outre une zone de raccord 30A entre la zone de déplacement 14 et la zone d'assemblage 15. La première couche hydrophobe 13 présente ainsi une première surface 14 formant ladite zone de déplacement 14 de fluide, une deuxième surface 15 formant ladite zone d'assemblage 15 et située au niveau des murs 30, et une troisième surface de raccord 30A entre lesdites première et deuxième surfaces 14, 15 et située au niveau des murs 30.
La figure 2 illustre un second mode de réalisation préféré de l'invention et ne diffère de la figure 1 que dans la mesure où les murs sont formés d'un seul tenant avec la couche support du substrat inférieur 1.

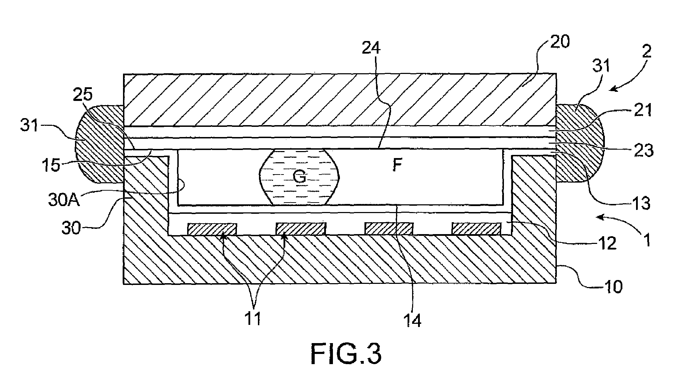

La figure 3 illustre un troisième mode de réalisation préféré de l'invention, qui diffère essentiellement du second mode de réalisation préféré par la position de l'adhésif.

Dans les figures 2 et 3, les références numériques identiques à celles de la figure 1 indiquent des éléments identiques ou similaires.

Selon ces trois modes de réalisation, les couches hydrophobes 13, 23 sont réalisées à partir d'un polysiloxane.

Par polysiloxane, on entend un polymère dont le squelette macromoléculaire est basé sur l'enchaînement -Si-O-, et le rapport entre le nombre de liaisons - Si-O- linéaires et le nombre de liaisons -Si-O-cycliques est noté r.

De préférence, le rapport r est inférieur ou égal à 0,4 ou, avantageusement, inférieur ou égal à 0,3.

Le matériau à base de polysiloxane avec une telle conformation est obtenu par dépôt chimique en phase vapeur assisté par un plasma, également appelé PECVD, tel que décrit dans la demande WO 2007/003754 A1 déposée au nom de la demanderesse, de telle sorte que ledit matériau présente une hydrophobie importante et une faible hystérésis d'angle de contact. De préférence, lesdites couches hydrophobes 13, 23 ne présentent pas de propriétés élastiques.

Comme décrit précédemment, la couche hydrophobe 13 recouvre, au niveau du substrat 1, la couche diélectrique 12 et les parois internes des murs 30.

La couche hydrophobe 23 du capot 2 peut recouvrir ou non la contre-électrode 21. La contre-électrode 21 peut être une électrode planaire, un fil ou une piste déposée à la surface de la couche de fermeture 20, ou enterrée dans cette couche 20, ou déposée à la surface de la couche hydrophobe 23.

Chaque couche hydrophobe 13, 23 comprend une zone d'assemblage 15, 25 disposée en regard l'une de l'autre.

Le substrat 1 et le capot 2 sont assemblés l'un à l'autre au niveau des zones d'assemblages 15, 25 des couches hydrophobes 13, 23.

L'assemblage est réalisé au moyen d'un adhésif 31 à base de silicone.

Le terme adhésif est ici employé comme synonyme de colle. Ledit adhésif est de préférence un élastomère silicone.

Selon les premier et second modes de réalisation préférés de l'invention (figures 1 et 2), l'adhésif 31 à base de silicone est disposé entre les zones d'assemblages 15, 25 des couches hydrophobes 13, 23 et au contact de celles-ci.

Dans le troisième mode de réalisation préféré de l'invention (figure 3), les couches hydrophobes 13 et 23 sont au moins partiellement en contact l'une avec l'autre au niveau des zones d'assemblage 15, 25. L'adhésif 31 est alors disposé à la périphérie extérieure de la jointure desdites zones d'assemblage 15 et 25. Plus précisément, l'adhésif 31 est disposé contre le substrat 1 et le capot 2, en contact avec la périphérie extérieure des couches hydrophobes 13 et 23 au niveau des zones d'assemblage 15 et 25. Ainsi, l'adhésif 31 n'est pas localisé entre les couches hydrophobes 13 et 23.

Dans ces trois modes de réalisation préférés de l'invention, l'adhésif 31 forme un joint étanche entre le substrat 1 et le capot 2.

Par silicone, on entend un polyorganosiloxane formé d'une chaîne ou d'un réseau -Si-O- sur lequel se fixent des groupes complémentaires organiques, de type méthyle (-CH3) par exemple, au niveau des atomes de silicium.

Le silicone peut également présenter un groupe organique rattaché à un des atomes de silicium par une chaîne de plusieurs carbones, tel que représenté ci-dessous dans sa forme vulcanisée, et référencé (A), où y est un groupe organique, m varie entre 1 et 25, et n entre 0 et 1000. Ce type de produit chimique est parfois appelé siloxane organo-modifié.

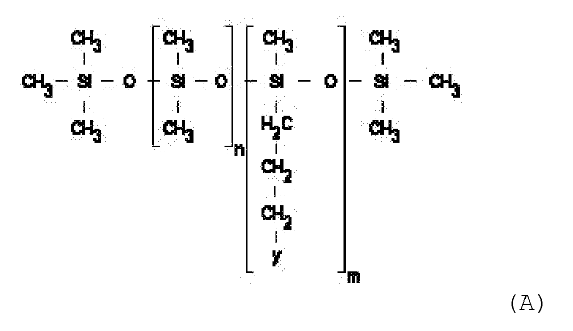

L'adhésif peut être à base de silicone monocomposant ou bicomposant. Il peut également être fluoré.

Un adhésif à base de fluorosilicone comprend des chaînes à base de siloxane (-Si-O-Si-O-) dont les ramifications portent des groupements fluorés ou perfluorés de type -CF₃. Ce type d'adhésif présente un taux de fluor variant entre, par exemple, 20 et 60%.

A titre d'exemple non limitatif, l'adhésif à base de silicone peut être choisi parmi les colles MED1511, MED6215, MED1-4013, MED-4013 commercialisées par Nusil Technology. L'adhésif à base de fluorosilicone peut être du FS3730 commercialisé par Nusil Technology.

Il est à noter que les adhésifs MED 1511 et FS 3730 présentent, de manière surprenante, de meilleures propriétés adhésives que l'adhésif MED1-4013 sur les couches hydrophobes décrites précédemment.

Le MED 1511 et le FS 3730 sont des adhésifs monocomposant ayant un mode de vulcanisation par condensation (le catalyseur étant l'eau) avec dégagement d'acide acétique. La vulcanisation peut être effectuée à température ambiante.

Le MED1-4013 est un bicomposant vulcanisant lors du mélange des deux composants où le catalyseur est du platine. La vulcanisation peut être effectuée à température ambiante.

Le phénomène de vulcanisation peut être défini comme suit. Un adhésif siliconé est constitué de chaînes de polymère indépendantes. En présence d'un catalyseur, ses chaînes se lient entre elles par des liaisons covalentes (ce phénomène est appelé réticulation) avec le plus souvent dégagement d'un produit tiers.

Pour les monocomposants, l'humidité ambiante est le catalyseur le plus commun.

Pour des adhésifs bicomposants, le catalyseur est l'un des composants.

Lors de la vulcanisation, l'adhésif réticulé devient moins plastique et davantage élastique.

Le dégagement d'acide acétique lors de la vulcanisation de l'adhésif est dû à la présence d'un radical acétate dans la structure chimique de l'adhésif.

Aussi, de préférence, l'adhésif à base de silicone est choisi de manière à comporter un radical acétate.

La réalisation d'un dispositif microfluidique selon les premier et second modes de réalisation préférés va maintenant être décrite en détail.

Le substrat 1 comporte une couche support 10, par exemple en SiO₂, de préférence plane selon le premier mode de réalisation préféré de l'invention.

La structuration des électrodes 11 peut être obtenue par des méthodes classiques des micro-technologies, par exemple par photolithographie et gravure. Les électrodes 11 sont par exemple réalisées par dépôt d'une couche métallique (Au, Al, ITO, Pt, Cr, Cu, ...) par pulvérisation ou évaporation.

Le substrat 1 est ensuite recouvert d'une couche diélectrique 12 en Si₃N₄, SiO₂,...

Des murs 30 sont formés sur la couche diélectrique 12 à la bordure du substrat 1 pour délimiter une cavité microfluidique, et éventuellement à l'intérieur de celle-ci pour définir des zones de déplacement des gouttes, selon l'agencement des électrodes 11.

Les murs 30 permettent de définir également une distance précise de positionnement du capot 2 vis-à-vis du substrat 1.

Selon le premier mode de réalisation préféré de l'invention illustré sur la figure 1, ils peuvent être formés en résine photosensible déposée à la tournette, par dépôt de film photosensible ou d'un polymère. De préférence, les murs 30 sont réalisés en Ordyl, par exemple le SY300 commercialisé par Elga Europe.

Selon le second mode de réalisation préféré de l'invention représenté sur la figure 2, les murs 30 sont formés d'un seul tenant avec la couche support par photolithographie sur résine épaisse déposée par spin coating ou dip coating, photolithographie ou lamination d'un film adhésif, éventuellement par sérigraphie.

L'épaisseur des électrodes 11 est de quelques dizaines de nanomètres à quelques microns, par exemple comprise entre 10 nm et 1 µm. La largeur du motif des électrodes 11 est de quelques microns à quelques millimètres (électrodes planes).

Les deux substrats 1 et 2 sont typiquement distants d'une distance comprise entre, par exemple, 10 µm et 100 µm ou 500 µm.

Quel que soit le mode de réalisation considéré, une goutte de liquide aura un volume compris entre, par exemple, quelques picolitres et quelques microlitres, par exemple entre 1 pl ou 10 pl et 5 µl ou 10 µl.

En outre, chacune des électrodes 11 a par exemple une surface de l'ordre de quelques dizaines de µm² (par exemple 10 µm²) jusqu'à 1 mm², selon la taille des gouttes à transporter, l'espacement entre électrodes voisines étant par exemple compris entre 1 µm et 10 µm.

La couche hydrophobe 13, 23 est obtenue par une technique de dépôt en phase vapeur, assisté par plasma (PECVD), technique connue de l'homme du métier.

Cette technique est cependant optimisée, selon des caractéristiques décrites dans la demande WO 2007/003754 A1 déposée au nom de la demanderesse.

Le précurseur est de préférence le octaméthylcyclotétrasiloxane, également noté OMCTS.

Par ailleurs, les conditions de dépôt sont les suivantes, telles que décrites dans la demande de brevet WO 2007/003754 A1.

La pression dans l'enceinte de dépôt peut être comprise entre 0,1 et 1 mbar, la puissance RF appliquée à l'électrode générant le plasma peut être comprise entre 10 et 400 W, et le débit de précurseur peut être compris entre 10⁻⁴ et 10⁻² mol/min. Le débit d'hélium peut être compris entre 0 et 500 sccm.

Des exemples de dépôt du matériau ainsi que des analyses sur les propriétés dudit matériau sont détaillées dans la demande de brevet WO 2007/003754 A1.

Les couches hydrophobes 13, 23 sont formées d'un matériau présentant ainsi la conformation décrite précédemment.

Les couches 13, 23 sont ainsi hydrophobes et présentent un angle de contact de 107° environ. De plus, l'hystérésis de mouillage est particulièrement faible puisqu'inférieure à 10°, voire inférieure à 5°.

De plus, la couche hydrophobe 13 est déposée à la surface du substrat 1, plus précisément à la surface de la couche diélectrique 12 et des murs 30, et présente une épaisseur sensiblement homogène.

L'étape de dépôt des couches hydrophobes 13, 23 est ensuite directement suivie de l'étape de collage desdits substrats 1, 2.

Selon les premier et second modes de réalisation préférés de l'invention, l'adhésif 31 peut être déposé par toute technique permettant d'obtenir une couche mince localisée d'un fluide visqueux (flexo, héliographie, dépôt par pipette). Par exemple, manuellement ou automatiquement, à l'aide d'un dispositif approprié du type pipette, sur l'une ou les deux couche(s) hydrophobe(s) 13, 23.

En variante, il peut être déposé par une technique de sérigraphie décrite dans la demande de brevet WO 2004/112961 A1 déposée au nom de la demanderesse.

Dans ce cas, les différentes zones d'assemblage 15 de la couche hydrophobe 13 sont, de préférence, sensiblement coplanaires.

Le procédé de dépôt de l'adhésif 31 consiste à :
- mettre en place une grille au-dessus du substrat 1.
- enduire cette grille de l'adhésif, au moyen d'un outil (non représenté) qui, par appui sur la grille, met localement cette grille en contact avec les zones d'assemblage, de manière à déposer un film de gouttelettes d'adhésif sur ces zones d'assemblage, et
- retirer la grille.

Cette technique de sérigraphie comporte des caractéristiques et des variantes décrites dans la demande de brevet citée précédemment.

L'adhésif à base de silicone utilisé dans la technique de sérigraphie est de préférence des colles thixotropes de viscosité 32000cP, par exemple la colle Delo-KatioBond référence 45952 commercialisée par Delo. La colle FS3730, citée précédemment, peut également convenir.

De préférence, la viscosité de l'adhésif est comprise entre 1400cP et 100000cP.

La grille utilisée peut être du tissu polyester 150-31 commercialisé par Dubuit. L'outil d'enduction de la grille peut être une racle, par exemple la racle PV 95A commercialisée par Aclathan.

Quelle que soit la technique de dépôt de l'adhésif, le capot 2 est ensuite plaqué et maintenu par serrage jusqu'à complète vulcanisation de l'adhésif 31.

Enfin, pour assurer une meilleure étanchéité du dispositif microfluidique, un cordon d'adhésif 31 peut être déposé à la jointure du substrat 1 et du capot 2, et sur toute la surface extérieure périphérique du dispositif, comme décrit précédemment en référence à la figure 3. Le cordon peut avoir un diamètre sensiblement égal à la hauteur cumulée du substrat 1 et du capot 2 assemblés, par exemple de l'ordre du millimètre.

Le dispositif microfluidique peut ensuite être rempli d'une huile minérale ou silicone, par l'intermédiaire d'orifices pratiqués dans le capot 2 et débouchant à l'intérieur de la cavité microfluidique.

Certains orifices peuvent communiquer avec des réservoirs d'échantillons liquides, de diluants ou de réactifs.

Le dispositif peut être utilisé pour toutes les applications biologiques, biochimiques ou chimiques, notamment la détection des pathogènes.

Selon le troisième mode de réalisation préféré de l'invention illustré sur la figure 3, les substrats 1 et 2 sont disposés l'un par rapport à l'autre de manière à ce que les couches hydrophobes 13 et 23 soient au moins partiellement en contact mutuel au niveau des zones d'assemblage 15 et 25.

Un cordon d'adhésif 31 est déposé à la périphérie extérieure de la jointure des zones d'assemblages 15, 25. Le cordon peut avoir un diamètre sensiblement égal à la hauteur cumulée du substrat 1 et du capot 2 assemblés, par exemple de l'ordre du millimètre.

Des tests ont été réalisés pour analyser la tenue à la rupture de l'assemblage des substrats 1 et 2 d'un dispositif microfluidique selon le premier mode de réalisation préféré de l'invention (figure 1).

Pour cela, un orifice est prévu dans le capot 2 pour communiquer avec la cavité microfluidique à partir de l'extérieur du dispositif.

Cet orifice est relié à la sortie d'une seringue actionnée par un pousse-seringue.

Dans ces tests, la cavité microfluidique est fermée de manière étanche. Elle est reliée à la seringue par l'orifice du capot, de sorte que la pression dans la ligne reliant la seringue à l'orifice corresponde à la pression dans la cavité microfluidique.

Un capteur de pression est prévu pour mesurer la pression imposée. Le capteur de pression est connecté à la sortie de la seringue et mesure la pression dans la ligne.

Lors de ces tests, la pression dans la cavité microfluidique est augmentée par petits incréments. Un temps de relaxation de quelques dizaines de secondes est prévu, par exemple 25 secondes, avant la lecture de la valeur de la pression.

Tant que le capot et le substrat sont assemblés l'un à l'autre de manière étanche, la pression dans la cavité microfluidique augmente linéairement, en fonction du nombre d'incréments du pousse-seringue.

Lorsqu'il y a rupture de l'adhésif 31, la pression dans la cavité microfluidique chute brutalement. La pression maximale supportée par l'adhésif avant rupture peut ainsi être déterminée.

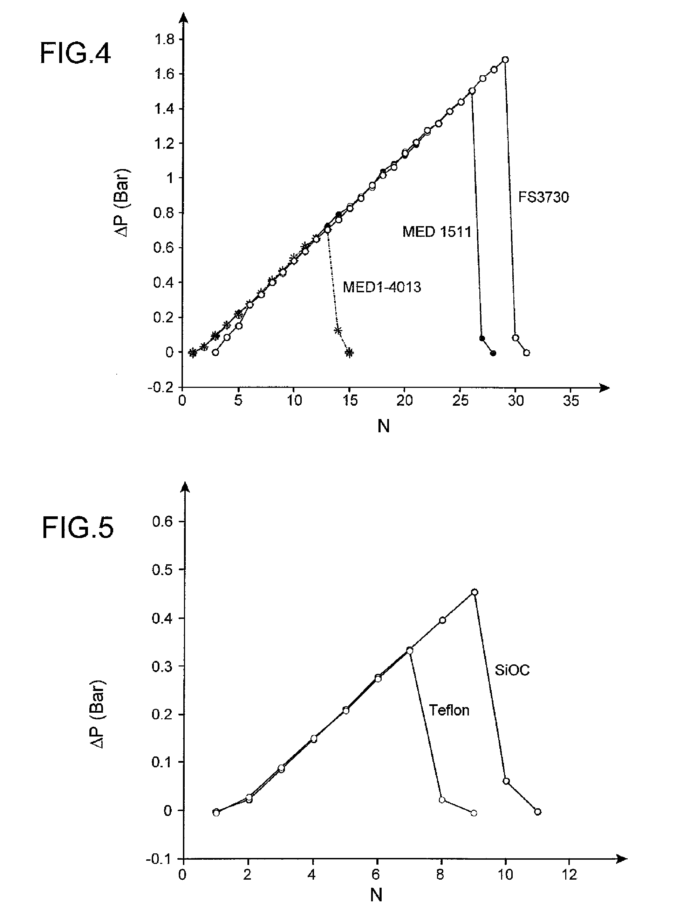

Les figures 4 et 5 illustrent les résultats des tests de rupture de l'assemblage des substrats 1, 2, réalisés avec le montage expérimental décrit précédemment.
La figure 4 donne l'évolution de la pression relative ΔP en fonction du nombre N d'incréments d'augmentation de pression par le pousse-seringue.

ΔP est la différence de pression entre la pression dans la cavité microfluidique et une pression de référence, par exemple la pression atmosphérique.

La couche hydrophobe est du polysiloxane pour lequel le rapport entre les liaisons -Si-O- linéaires et les liaisons -Si-O- cycliques est inférieur ou égal à 0,4. Différentes colles sont testées, à savoir le MED1-4013, le MED-1511 et le FS3730 cités précédemment.

Les résultats montrent une résistance à la rupture plus importante dans le cas des colles MED-1511 et FS3730 que dans le cas de la colle MED1-4013.

Il est rappelé qu'à la différence de la colle bicomposant MED1-4013, les colles MED-1511 et FS3730 sont des monocomposants qui vulcanisent par condensation avec dégagement d'acide acétique. Le dégagement d'acide acétique montre que les chaînes de polymères de ces colles comportent un radical acétate.

Il est donc préférable d'utiliser un adhésif 31 à base de silicone comportant un radical acétate et donc vulcanisant avec dégagement d'acide acétique, comme par exemple les colles MED-1511 et FS3730.

La figure 5 illustre l'évolution de la pression ΔP en fonction du nombre N d'incréments d'augmentation de pression par le pousse-seringue.

Le montage expérimental est identique au précédent. Cependant, pour ce test, l'adhésif utilisé est la colle MED-1511 citée précédemment, et deux matériaux de couches hydrophobes 15, 25 sont testés, à savoir, le Téflon^{®}, et le SiOC pour lequel le rapport entre les liaisons -Si-O- linéaires et les liaisons -Si-O-cycliques est inférieur ou égal à 0,4.

La courbe montre clairement une meilleure tenue à la rupture de l'adhésif à base de silicone lorsque les couches hydrophobes sont à base de polysiloxane que lorsqu'elles sont à base de matériau fluoré tel que du Téflon^{®}.

Enfin, différentes colles non silicones sont testées avec le montage expérimental décrit précédemment. L'assemblage par collage des substrats 1 et 2 n'a pas pu être obtenu. Les colles testées sont les suivantes :
- Colles epoxy : EPO-TEK^{®} 353-ND, H70-E2, OG116 commercialisées par Epoxy Technology, 18S, 15X_2 commercialisées par Master Bond Inc., E701 commercialisée par Epotecny, KB 45952, KB 554 et KB 4557 commercialisées par Synéo ;
- Colles acryliques : Vitralit^{®} 6108T, 9181, 5140, 6128 et 9181 commercialisées par Eleco ;
- Colles araldites : Araldite^{®} 2021 commercialisée par Huntsman ;
- Colles polyuréthanes : DP5003 commercialisée par 3M, PU15 commercialisée par Henkel ;
- Colle néoprène : Sader^{®} ;
- Colle cyanoacrylate : Loctite^{®} 4014.

Ce dernier test montre la synergie importante et surprenante, en termes d'adhésion, entre les couches hydrophobes à base de polysiloxane et les adhésifs à base de silicone.

Bien entendu, diverses modifications peuvent être apportées par l'homme du métier à l'invention qui vient d'être décrite, uniquement à titre d'exemples non limitatifs.

Par ailleurs, les couches hydrophobes 13 et 23 peuvent être formées d'un polysiloxane déposé par d'autres techniques, telles que le trempage (dip-coating) ou le tournage (spin-coating), voire le dépôt en phase vapeur (CVD).

Dans le dernier cas, le précurseur peut être choisi parmi la liste non limitative comprenant l'octaméthylcyclotétrasiloxane et ses dérivés, le tétraméthylcyclotétrasiloxane et ses dérivés, l'hexaméthyldisiloxane et ses dérivés, le triméthylsilane et ses dérivés, le tétraméthylsilane et ses dérivés et le bis-triméthylsilylméthane et ses dérivés.

## Revendications

1. Dispositif microfluidique comprenant un premier et un second substrats (1, 2) comportant, respectivement, une première et une seconde couches hydrophobes (13, 23) à base de polysiloxane, lesdites couches hydrophobes comprenant chacune une zone d'assemblage (15, 25),
**caractérisé en ce que** lesdits substrats (1, 2) sont assemblés l'un à l'autre au niveau des zones d'assemblage (15, 25) desdites couches hydrophobes (13, 23) au moyen d'un adhésif (31) à base de silicone.

2. Dispositif microfluidique selon la revendication 1, **caractérisé en ce que** le premier substrat (1) comprend au moins un mur (30) disposé de manière à délimiter, conjointement avec ledit second substrat (2), une cavité microfluidique de déplacement de fluide, ladite première couche hydrophobe (13) recouvrant au moins partiellement ledit mur (30).

3. Dispositif microfluidique selon la revendication 2, **caractérisé en ce que** ladite première couche hydrophobe (13) comprend une première surface (14) formant une surface de déplacement de fluide, une deuxième surface (15) formant ladite zone d'assemblage et située au niveau dudit mur (30), et une troisième surface (30A) de raccord entre lesdites première et deuxième surfaces (14, 15) et située au niveau dudit mur (30).

4. Dispositif microfluidique selon la revendication 2 ou 3, **caractérisé en ce que** ledit mur (30) est un élément rapporté disposé au niveau dudit premier substrat (1) ou est formé d'un seul tenant avec ledit premier substrat (1).

5. Dispositif microfluidique selon l'une quelconque des revendications 1 à 4, **caractérisé en ce que** lesdites couches hydrophobes (13, 23) sont à base d'un polysiloxane pour lequel le rapport entre les liaisons -Si-O- linéaires et les liaisons -Si-O- cycliques est inférieur ou égal à 0,4.

6. Dispositif microfluidique selon l'une quelconque des revendications 1 à 5, **caractérisé en ce que** ledit adhésif (31) est un élastomère silicone.

7. Dispositif microfluidique selon l'une quelconque des revendications 1 à 6, **caractérisé en ce que** ledit adhésif (31) est à base de fluorosilicone.

8. Dispositif microfluidique selon l'une quelconque des revendications 1 à 7, **caractérisé en ce que** ledit adhésif (31) est disposé entre les zones d'assemblages (15, 25) desdites couches hydrophobes (13, 23).

9. Dispositif microfluidique selon l'une quelconque des revendications 1 à 7, **caractérisé en ce que** les zones d'assemblage (15, 25) desdites couches hydrophobes (13, 23) sont au moins partiellement en contact mutuel, ledit adhésif (31) étant situé à la périphérie extérieure de la jointure desdites zones d'assemblage (15, 25).

10. Dispositif microfluidique selon l'une quelconque des revendications 1 à 9, **caractérisé en ce que** ledit premier substrat (1) comprend un réseau d'électrodes (11) recouvertes d'une couche diélectrique (12), ladite première couche hydrophobe (13) recouvrant ladite couche diélectrique (12), et **en ce que** ledit second substrat (2) comprend une contre-électrode (21).

11. Procédé d'assemblage d'un premier et d'un second substrats (1, 2) l'un à l'autre, lesdits substrats comportant, respectivement, une première et une seconde couches hydrophobes (13, 23) à base de polysiloxane, lesdites couches hydrophobes comprenant chacune une zone d'assemblage (15, 25), ledit procédé étant **caractérisé en ce qu'**il comprend une étape de collage desdits substrats (1, 2) l'un à l'autre au niveau des zones d'assemblage (15, 25) desdites couches hydrophobes (13, 23) au moyen d'un adhésif (31) à base de silicone.

12. Procédé d'assemblage selon la revendication 11, **caractérisé en ce que**, préalablement à ladite étape de collage, lesdites première et seconde couches hydrophobes (13, 23) sont formées, respectivement, à la surface desdits premier et second substrats (1, 2) par dépôt chimique en phase vapeur, assisté par plasma dans lequel est injecté un précurseur choisi parmi les organosiloxanes cycliques et les organosilazanes cycliques, le rapport entre la densité de puissance dissipée dans le plasma et le débit de précurseur injecté dans le plasma étant inférieur ou égal à 100 W.cm⁻²/mol.min⁻¹.

13. Procédé d'assemblage selon la revendication 12, **caractérisé en ce que** le précurseur est choisi parmi l'octométhylcyclotétrasiloxane et ses dérivés.

14. Procédé d'assemblage selon la revendication 12 ou 13, **caractérisé en ce que** ladite étape de collage desdits substrats (1, 2) est directement précédée de ladite étape de dépôt desdites première et seconde couches hydrophobes (13, 23) à la surface, respectivement, desdits premier et second substrats (1, 2).

15. Procédé d'assemblage selon l'une quelconque des revendications 12 à 14, **caractérisé en ce que** ledit premier substrat (1) comprend au moins un mur (30) disposé de manière à délimiter, conjointement avec ledit second substrat (2), une cavité microfluidique de déplacement de fluide, ladite étape de dépôt de la première couche hydrophobe (13) étant réalisée de sorte que ladite première couche hydrophobe (13) recouvre au moins partiellement ledit mur (30).

16. Procédé d'assemblage selon l'une quelconque des revendications 11 à 15, **caractérisé en ce que** ladite étape de collage comprend une étape de vulcanisation dudit adhésif (31) avec dégagement d'acide acétique.
